Europäisches Patentamt

European Patent Office

Office européen des brevets

(19)

(11) Veröffentlichungsnummer: **0 190 585**
**A1**

(12) # EUROPÄISCHE PATENTANMELDUNG

(21) Anmeldenummer: 86100585.8

(22) Anmeldetag: 17.01.86

(51) Int. Cl.4: **H01L 29/72** , H01L 29/743 , H01L 29/08 , H01L 29/52

(30) Priorität: 01.02.85 DE 3503459

(43) Veröffentlichungstag der Anmeldung:
13.08.86 Patentblatt 86/33

(84) Benannte Vertragsstaaten:
DE FR GB IT

(71) Anmelder: **Siemens Aktiengesellschaft Berlin und München**
**Wittelsbacherplatz 2**
**D-8000 München 2(DE)**

(72) Erfinder: **Bechteler, Martin, Dr.**
**Nelkenweg 10**
**D-8011 Kirchheim(DE)**
Erfinder: **Gross, Wolfgang, Dr.**
**Münchner Strasse 111 A**
**D-8043 Unterföhring(DE)**

(54) **Abschaltbares Halbleiterbauelement.**

(57) Bei Leistungstransistoren und GTO-Thyristoren müssen die Emitterzonen sehr schmal sein, damit der Emitter beim Ausräumen der Speicherladung nicht in Durchlaßrichtung vorgespannt wird. Die Kontaktierung sehr schmaler Emitterstreifen erfordert aber hohe Präzision. Es lassen sich auch mit relativ breiten Emitterstreifen befriedigende Ergebnisse erzielen, wenn sie in quer zum Streifen liegende Inseln (4) unterteilt sind. Zwischen den Inseln wird die Basiszone (3) durch Isolierschichten (8) gegen die Emittermetallisierung (5) isoliert.

FIG 1

EP 0 190 585 A1

Abschaltbares Halbleiterbauelement

Die Erfindung bezieht sich auf ein abschaltbares Halbleiterbauelement mit einem Halbleiterkörper mit einer Basiszone vom ersten Leitungstyp, die an eine Oberfläche des Halbleiterkörpers reicht, mit einer Steuerelektrode, die die Basiszone kontaktierende Streifen aufweist, mit mindestens einer in die Basiszone eingebetteten streifenförmigen Emitterzone, die an die Oberfläche des Halbleiterkörpers grenzt und die von einem Streifen einer Streifen aufweisenden Emitterelektrode kontaktiert ist. Das abschaltbare Halbleiterbauelement kann ein Leistungstransistor oder ein GTO-Thyristor sein.

Ein GTO-Thyristor der genannten Art ist beispielsweise in der Zeitschrift "Electronics", 14. Juli 1981, Seite 129 bis 131 beschrieben worden. Die Basiselektrode und die Emitterelektrode ist jeweils kammförmig ausgebildet, wobei immer abwechselnd ein Streifen der Steuerelektrode neben einem Streifen der Emitterelektrode liegt. Die streifenförmige Ausbildung insbesondere der Emitterelektroden und der darunterliegenden Emitterzonen hat den Zweck, daß der beim Abschalten lateral unter dem Emitter fließende Ausräumstrom nur einen Spannungsabfall erzeugt, der gerade nicht dazu ausreicht, den pn-Übergang zwischen Emitterzone und Basiszonen in Durchlaßrichtung vorzuspannen. Je schneller der Thyristor bei sonst unveränderten Parametern ausgeräumt werden soll, desto höher wird dieser Strom. Man ist daher gezwungen, mit steigender Abschaltgeschwindigkeit die Emitterzonen und damit die Streifen der Emitterelektrode immer schmaler zu machen. Dies stellt bei Breiten von z. B. 50 μm erhebliche Anforderungen an die Justiergenauigkeit.

Der Erfindung liegt die Aufgabe zugrunde, ein abschaltbares Halbleiterbauelement der erwähnten Art so weiterzubilden, daß die Abschaltgeschwindigkeit im wesentlichen unabhängig von der Breite der Emitterelektroden wird.

Diese Aufgabe wird gelöst durch die Merkmale:

a) Unter dem Streifen der Emitterelektrode ist eine Vielzahl von streifenförmigen Emitterinseln im Abstand voneinander angeordnet,

b) die streifenförmigen Emitterinseln liegen quer zur Längsrichtung des Streifens der Emitterelektrode,

c) der Streifen der Emitterelektrode ist zwischen den streifenförmigen Emitterinseln gegen die Basiszone isoliert.

Weiterbildungen sind Gegenstand der Unteransprüche.

Die Erfindung wird anhand einiger Ausführungsbeispiele in Verbindung mit den Fig. 1 bis 3 näher erläutert. Es zeigen:

Fig. 1 eine perspektivische Ansicht eines ersten Ausführungsbeispiels eines GTO-Thyristors,

Fig. 2 die Aufsicht auf den GTO-Thyristor nach Fig. 1 und

Fig. 3 die Aufsicht auf ein anderes Ausführungsbeispiel der Erfindung.

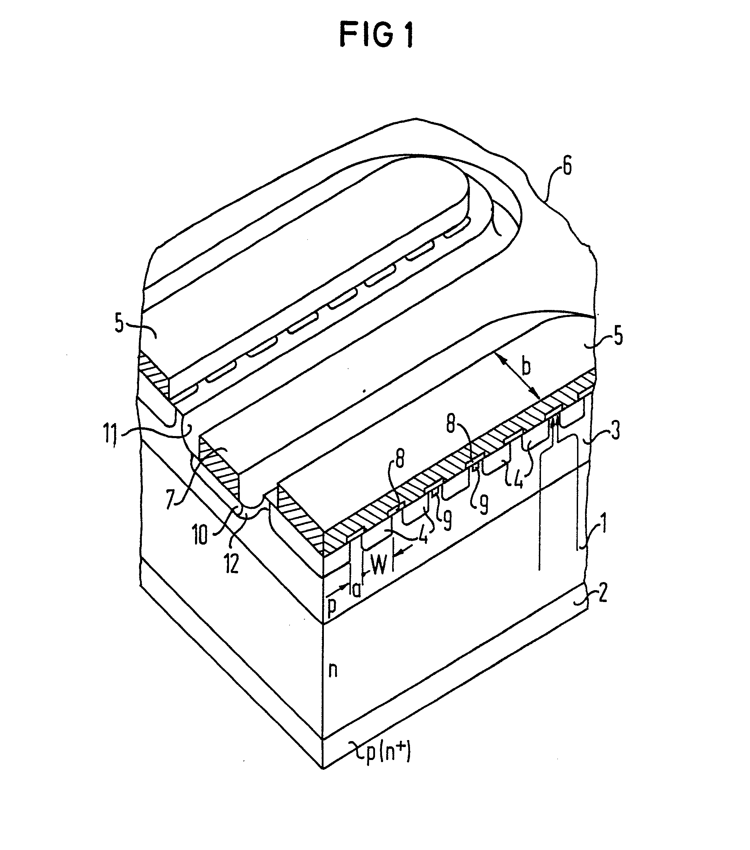

Der GTO-Thyristor nach Fig. 1 hat einen Halbleiterkörper mit vier übereinanderliegenden Zonen abwechselnden Leitungstyps. Die Mittelzone ist mit 1 bezeichnet, die anodenseitige Außenzone mit 2, die katodenseitige Basiszone mit 3 und die katodenseitige Emitterzone mit 4.

Die Zonen haben von der Katoden- zur Anodenseite den Leitfähigkeitstyp npnp, die Zonenfolge kann jedoch auch umgekehrt sein. Die Basiszone 3 erstreckt sich bis zur oberen Oberfläche des Halbleiterkörpers. Sie ist einteilig ausgebildet und bedeckt die Mittelzone vollständig. Die Emitterzone besteht nicht aus einer einzigen durchgehenden Zone, sondern aus einer Vielzahl von einzelnen, streifenförmigen Emitterinseln 4. Diese Emitterinseln sind voneinander getrennt und haben untereinander einen Abstand a. Ihre Breite ist mit b bezeichnet. Die Emitterinseln sind von einem Streifen 5 einer Emitterelektrode kontaktiert. Sie liegen quer zur Längsrichtung des Streifens 5. Gegen die Basiszone 3 ist der Streifen 5 der Emitterelektrode durch Isolierschichten 8 elektrisch isoliert. Diese bestehen aus den in der Halbleitertechnik üblichen Isolierstoffen wie Siliciumdioxid $SiO_2$ oder Siliciumnitrid $Si_3N_4$ oder Kombinationen davon.

Zur Erzielung einer hohen Ausräumgeschwindigkeit ist die Breite w der Emitterinseln 4 kleiner als die Breite b des Streifens 5 der Emitterelektrode. Ist die Breite b z. B. 150 μm, so beträgt die Breite w der Emitterinseln 4 vorzugsweise weniger als 50 μm. Der Abstand a zwischen den Emitterinseln 4 ist so groß, daß der Querschnitt zwischen den Emitterinseln den Ausräumstrom tragen kann. Er kann beispielsweise zwischen 10 und 50 μm liegen.

Neben dem Streifen 5 ist ein Streifen 7 einer Steuerelektrode 6 angeordnet. Dieser Streifen 7 kann in einer in der Oberfläche der Basiszone 3 vorgesehenen Wanne 11 liegen, er kann jedoch auch in gleicher Höhe der Emitterelektrode liegen, wenn durch eine entsprechende Ausbildung des Katodenkontakts dafür gesorgt wird, daß kein Kurzschluß zwischen Steuerelektrode und Emitterelektrode auftritt. Zur besseren Kontaktierung der Basiszone 3 durch die Steuerelektrode 6 kann zwischen dem Streifen 7 und der Basiszone eine Kontaktierungsschicht 10 vom gleichen Leitfähigkeitstyp wie die Basiszone 3, jedoch von höherer Dotierungskonzentration angeordnet werden. Zur Verbesserung der Leitfähigkeit zwischen den Emitterinseln 4 können zwischen diesen an der Oberfläche der Basiszone 3 streifenförmige Zonen 9 angeordnet werden, die ebenfalls den gleichen Leitungstyp wie die Basiszonen 3, aber höhere Dotierungskonzentration als diese haben. Die Zonen 9 und die Schicht 10 können Teil ein und derselben Schicht sein, können also zusammenhängen.

Beim Abschalten fließen die auszuräumenden Ladungsträger der einen Polarität entlang der Pfeile zunächst in Richtung zur Emitterelektrode 5. Unmittelbar unter den Emitterinseln 4 fließen die Ladungsträger dann lateral unter den Emitterinseln weiter in den Zwischenraum zwischen den Emitterinseln 4. Dort finden sie in der Nähe der Oberfläche der Basiszone 3 den geringsten Widerstand vor und fließen dann zum Streifen 7 der Steuerelektrode 6 ab. Der maximale Spannungsabfall am pn-Übergang zwischen den Emitterinseln 4 und der Basiszone 3 ist durch den Ausräumstrom und denjenigen Bahnwiderstand in der Basiszone 3 bestimmt, der durch die halbe Breite und die Tiefe der Emitterinseln 4 definiert ist. Daß die Ladungsträger diesen Weg zur Oberfläche der Basiszone 3 nehmen, erklärt sich durch das übliche Diffusionsprofil mit einer vergleichsweise hohen Randdotierung der Basiszone 3. Verstärkt werden kann dieser Einfluß noch durch die erwähnten hochdotierten Zonen 9.

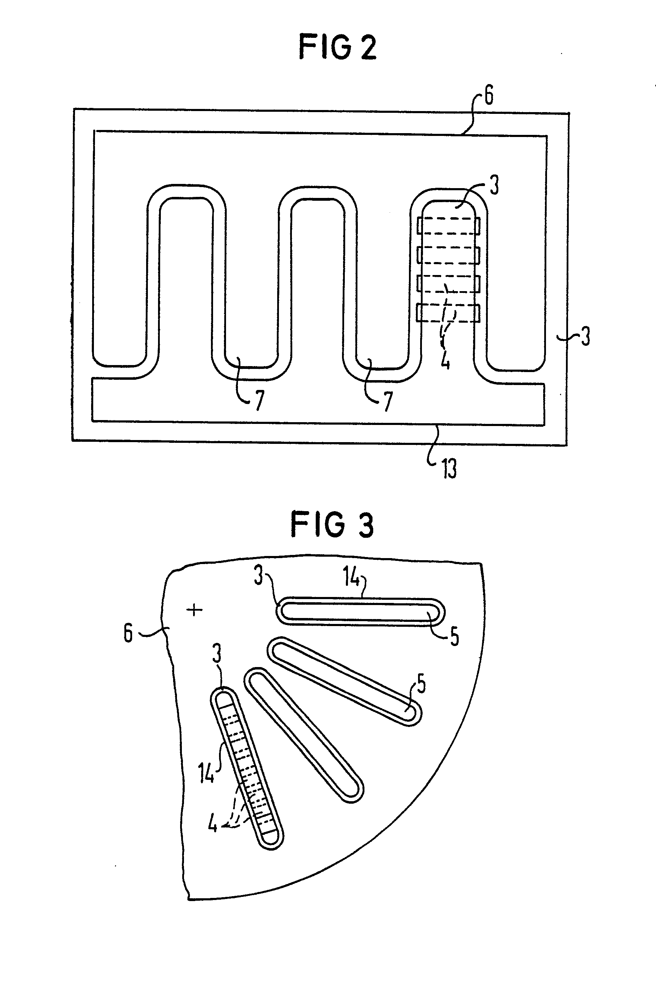

Die Fig. 2 zeigt die Aufsicht auf einen Thyristor nach Fig. 1 mit je einer vollständigen kammförmigen Steuerelektrode 6 und Emitterelektrode 13. Die Emitterinseln 4 sind gestrichelt und nur für einen Streifen 5 dargestellt, die isolierenden Zonen 8 wurden der besseren Übersichtlichkeit halber weggelassen.

In Fig. 3 ist ein Ausführungsbeispiel der Erfindung mit radialsymmetrischer Anordnung der Emitterelektroden und der Emitterinseln gezeigt. Gleiche und funktionsgleiche Teile wie in den Fig. 1 und 2 tragen auch hier die gleichen Bezugsziffern.

Die Emitterelektroden 5 sind elektrisch voneinander getrennte Streifen, die in streifenförmigen Aussparungen 14 der Emitterelektrode 6 angeordnet sind. Die Isolierschichten 8 sind zur besseren Übersicht nicht dargestellt. Zwischen den Emitterinseln 4 können, wie in Verbindung mit Fig. 1 erläutert, ebenfalls die hochdotierten Zonen 9 liegen. Die Emitterelektroden 5 werden am fertigen Bauelement durch eine entsprechend geformte Katodenelektrode kontaktiert und einander parallelgeschaltet.

Die Erfindung wurde anhand von Ausführungsbeispielen für GT0-Thyristoren erläutert. Sie ist jedoch auch für Leistungstransistoren anwendbar. Ein Leistungstransistor unterscheidet sich im wesentlichen nur durch die Zonenfolge npnn$^+$ (Fig. 1) von einem GT0--Thyristor mit der Zonenfolge npnp.

## Ansprüche

1. Abschaltbares Halbleiterbauelement mit einem Halbleiterkörper mit einer Basiszone (3) vom ersten Leitungstyp, die an eine Oberfläche des Halbleiterkörpers reicht, mit einer Steuerelektrode (6), die die Basiszone (3) kontaktierende Streifen (7) aufweist, mit mindestens einer in die Basiszone eingebetteten streifenförmigen Emitterzone, die an die Oberfläche des Halbleiterkörpers grenzt und die von einem Streifen (5) einer Streifen aufweisenden Emitterelektrode (13) kontaktiert ist, **gekennzeichnet** durch die Merkmale:

a) Unter dem Streifen (5) der Emitterelektrode (13) ist eine Vielzahl von streifenförmigen Emitterinseln (4) im Abstand voneinander angeordnet,

b) die streifenförmigen Emitterinseln (4) liegen quer zur Längsrichtung des Streifens (5) der Emitterelektrode (13),

c) der Streifen (5) der Emitterelektrode (13) ist zwischen den streifenförmigen Emitterinseln (4) gegen die Basiszone (3) isoliert.

2. Abschaltbares Halbleiterbauelement nach Anspruch 1, **dadurch gekennzeichnet**, daß zwischen den streifenförmigen Emitterinseln (4) streifenförmige Zonen (9) des gleichen Leitungstyps wie die Basiszone (3) liegen, die höhere Dotierung als diese haben.

3. Abschaltbares Halbleiterbauelement nach Anspruch 1 oder 2, **dadurch gekennzeichnet**, daß zwischen dem Streifen (7) der Steuerelektrode (6) und der Basiszone (3) eine Kontaktierungszone (10) liegt, die den gleichen Leitungstyp wie die Basiszone (3) hat und höher dotiert ist als die Basiszone (3) an der Oberfläche des Halbleiterkörpers.

4. Abschaltbares Halbleiterbauelement nach Anspruch 2 und 3, **dadurch gekennzeichnet**, daß die Kontaktierungszone (10) und die zwischen den Emitterinseln (4) liegenden streifenförmigen Zonen (9) Teile ein und derselben Schicht sind.

5. Abschaltbares Halbleiterbauelement nach einem der Ansprüche 1 bis 4, **dadurch gekennzeichnet**, daß die Breite (b) der Streifen (5) der Emitterelektrode mindestens doppelt so groß wie die Breite (w) der Emitterinseln (4) ist.

6. Abschaltbares Halbleiterbauelement nach einem der Ansprüche 1 bis 5, **dadurch gekennzeichnet**, daß die Streifen der Emitterinseln und die Streifen (6) der Basiselektrode (7) einander parallel liegen und eine miteinander verzahnte Kammstruktur bilden.

7. Abschaltbares Halbleiterbauelement nach einem der Ansprüche 1 bis 5, **dadurch gekennzeichnet**, daß die Streifen (5) der Emitterelektrode (13) in Aussparungen (14) der Gateelektrode (6) radialsymmetrisch angeordnet sind.

8. Abschaltbares Halbleiterbauelement nach einem der Ansprüche 1 bis 7, **dadurch gekennzeichnet**, daß es ein GT0-Thyristor ist.

9. Abschaltbares Halbleiterbauelement nach einem der Ansprüche 1 bis 7, **dadurch gekennzeichnet**, daß es ein Leistungstransistor ist.

# FIG 1

# FIG 2

# FIG 3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. 4) |
|---|---|---|---|
| X | US-A-3 582 726 (G.J. GILBERT et al.) * Spalte 2, Zeile 54 - Spalte 3, Zeile 35; Figuren 2,3 * | 1,6,9 | H 01 L 29/72 H 01 L 29/743 H 01 L 29/08 H 01 L 29/52 |
| | --- | | |
| X | FR-A-1 586 205 (N.V. PHILIPS' GLOEILAMPENFABRIEKEN) * Seite 3, Zeile 27 - Seite 4, Zeile 18; Figur 1 * | 1,6,9 | |
| | --- | | |
| X | US-A-3 489 964 (T. MASUDA et al.) * Spalte 1, Zeilen 53-70; Figur 2 * | 1,6,9 | |
| | --- | | |
| A | FR-A-2 377 095 (ALSTHOM-ATLANTIQUE) * Anspruch 1; Figuren 5,6 * | 1,7,8 | RECHERCHIERTE SACHGEBIETE (Int. Cl. 4) |
| | ----- | | H 01 L |

Der vorliegende Recherchenbericht wurde für alle Patentansprüche erstellt.

| Recherchenort DEN HAAG | Abschlußdatum der Recherche 29-04-1986 | Prüfer ZOLLFRANK G.O. |
|---|---|---|